# EUROPEAN PATENT APPLICATION

(11) **EP 4 459 686 A1**
(43) Date of publication of application: **06.11.2024**
(21) Application number: 24171239.7
(22) Date of filing: 19.04.2024
(51) Int. Cl.: H01L 33/36, H01L 33/42, H01L 33/44

(54) **METHOD OF MANUFACTURING LIGHT EMITTING ELEMENT AND LIGHT EMITTING ELEMENT**

(30) Priority: 27.04.2023 JP 2023073598; 01.02.2024 JP 2024014326
(71) Applicant: Nichia Corporation, Anan-shi, Tokushima 774-8601 (JP)
(72) Inventor: KITAHAMA, Shun, Anan-shi, 774-8601 (JP)
(74) Representative: Betten & Resch

(57) **Abstract**

A method of manufacturing a light emitting element includes: providing a semiconductor structure including: an n-side semiconductor layer, an active layer positioned on the n-side semiconductor layer, and a p-side semiconductor layer positioned on the active layer; forming a light-transmissive conducting layer including: a first layer positioned on a portion of the upper surface of the p-side semiconductor layer, and a second layer covering the upper surface of the p-side semiconductor layer and the first layer; forming an insulation film covering the second layer; removing a portion of the insulation film in a region that overlaps the first layer in a plan view to form a first opening in the insulation film and to thereby expose the light-transmissive conducting layer from the insulation film; and forming a first conducting layer in the first opening such that the first conductive layer is electrically connected to the light-transmissive conducting layer.

## Description

### BACKGROUND

The present disclosure relates to a method of manufacturing a light emitting element and a light emitting element.

Japanese Patent Publication No. 2019-79979, for example, discloses forming a transparent electrode on the p-side semiconductor layer, forming a distributed Bragg reflector to cover the transparent electrode, and forming a p-contact electrode on the distributed Bragg reflector to be connected to the p-side semiconductor layer via an opening formed in the distributed Bragg reflector.

### SUMMARY

One object of the present invention is to provide a method of manufacturing a light emitting element in which electrical connection between a light-transmissive conducting layer and a conducting layer is established more reliably while reducing the absorption of light by the light-transmissive conducting layer.

According to one aspect of the present invention, a method of manufacturing a light emitting element includes: providing a semiconductor structure including an n-side semiconductor layer, an active layer positioned on the n-side semiconductor layer, and a p-side semiconductor layer positioned on the active layer; forming a light-transmissive conducting layer including a first layer formed on a portion of the upper surface of the p-side semiconductor layer and a second layer covering the upper surface of the p-side semiconductor layer and the first layer; forming an insulation film covering the second layer; removing a portion of the insulation film in a region that overlaps the first layer in a plan view to form a first opening in the insulation film to expose the light-transmissive conducting layer from the insulation film; and forming a first conducting layer in the first opening to be electrically connected to the light-transmissive conducting layer.

According to another aspect of the present invention, a light emitting element includes: a semiconductor structure including an n-side semiconductor layer, an active layer positioned on the n-side semiconductor layer, and a p-side semiconductor layer positioned on the active layer; a light-transmissive conducting layer including a first layer disposed on a portion of the upper surface of the p-side semiconductor layer, and a second layer covering the upper surface of the p-side semiconductor layer and the first layer; an insulation film covering the second layer and having a first opening located in a region overlapping the first layer in a plan view; and a first conducting layer disposed in the first opening and in contact with the light-transmissive conducting layer at a location below the first opening. A grain size of a portion of the second layer located on the first layer is greater than a grain size of the first layer.

According to certain embodiments of the present invention, a method of manufacturing a light emitting element and a light emitting element can be provided, in each of which electrically connection between the light-transmissive conducting layer and the conducting layer is established more reliably while reducing the absorption of light by the light-transmissive conducting layer.

### BRIEF DESCRIPTION OF THE DRAWINGS

FIG. 1 is a schematic plan view of a light emitting element according to an embodiment.
FIG. 2 is a schematic cross-sectional view taken along line II-II in FIG. 1.
FIG. 3 is a schematic cross-sectional view of a connection portion between the first conducting layer and the light-transmissive conducting layer in the light emitting element according to the embodiment.
FIG. 4A is a schematic cross-sectional view explaining a step in a method of manufacturing the light emitting element according to the embodiment.
FIG. 4B is a schematic cross-sectional view explaining a step in the method of manufacturing the light emitting element according to the embodiment.
FIG. 4C is a schematic cross-sectional view explaining a step in the method of manufacturing the light emitting element according to the embodiment.
FIG. 4D is a schematic cross-sectional view explaining a step in the method of manufacturing the light emitting element according to the embodiment.
FIG. 4E is a schematic cross-sectional view explaining a step in the method of manufacturing the light emitting element according to the embodiment.
FIG. 4F is a schematic cross-sectional view explaining a step in the method of manufacturing the light emitting element according to the embodiment.
FIG. 4G is a schematic cross-sectional view explaining a step in the method of manufacturing the light emitting element according to the embodiment.
FIG. 4H is a schematic cross-sectional view explaining a step in the method of manufacturing the light emitting element according to the embodiment.
FIG. 4I is a schematic cross-sectional view explaining a step in the method of manufacturing the light emitting element according to the embodiment.
FIG. 4J is a schematic cross-sectional view explaining a step in the method of manufacturing the light emitting element according to the embodiment.
FIG. 4K is a schematic cross-sectional view explaining a step in the method of manufacturing the light emitting element according to the embodiment.
FIG. 4L is a schematic cross-sectional view explaining a step in the method of manufacturing the light emitting element according to the embodiment.
FIG. 4M is a schematic cross-sectional view explaining a step in the method of manufacturing the light emitting element according to the embodiment.
FIG. 4N is a schematic cross-sectional view explaining a step in the method of manufacturing the light emitting element according to the embodiment.
FIG. 4O is a schematic cross-sectional view explaining a step in the method of manufacturing the light emitting element according to the embodiment.
FIG. 5A is a schematic plan view explaining a step in the method of manufacturing the light emitting element according to the embodiment.
FIG. 5B is a schematic plan view explaining a step in the method of manufacturing the light emitting element according to the embodiment.
FIG. 5C is a schematic plan view explaining a step in the method of manufacturing the light emitting element according to the embodiment.
FIG. 6A is an AFM image of a first layer in the light-transmissive conducting layer of the light emitting element according to the embodiment.
FIG. 6B is an AFM image of a second layer on the first layer in the light-transmissive conducting layer of the light emitting element according to the embodiment.

### DETAILED DESCRIPTION

Certain embodiments of the present invention will be described below with reference to the accompanying drawings. In the drawings, the same reference numerals are used to denote the same constituents. The drawings are schematic representation of the embodiments.
As such, the scale, spacing, or positional relationships of the members might be exaggerated, or a certain portion of a member omitted. As a cross-sectional view, an end view only showing a cut section might be used. In the cross-sectional views, no hatching is added to the cross section of the semiconductor structure in order to facilitate recognition of the boundaries of the layers of the semiconductor structure.

In the explanation below, common reference numerals are used to denote members having essentially the same functions for which redundant explanation might be omitted. Terms indicating specific directions or positions (for example, "on," "upper," or "under," "lower" or other terms related thereto) may occasionally be used. These terms, however, are merely used to clarify the relative directions or positions in a referenced drawing. As long as the relationship between relative directions or positions indicated with the terms such as "upper," "on," "lower," "under," or the like is the same as those in a referenced drawing, the layout of the elements in other drawings or actual products outside of the present disclosure does not have to be the same as those shown in the referenced drawing. Assuming that there are two members, for example, the positional relationship expressed by the term "on" in the present specification includes the case in which two members are in contact with each other and the case in which one is positioned above the other without being in contact with the other. Furthermore, in the present specification, unless otherwise specifically stated, the expression that a member covers an object includes the case in which the member is in contact with and directly covers the object and the case in which the member indirectly covers the object without being in contact with the object.

### Light Emitting Element

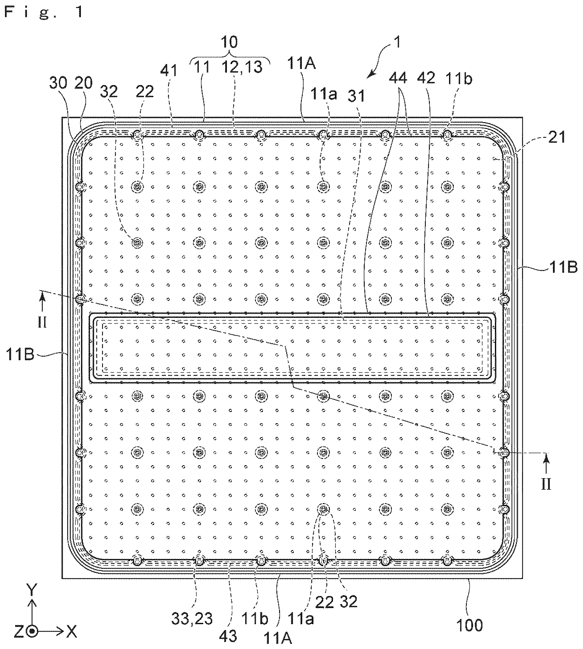

A light emitting element 1 according to an embodiment will be explained with reference to FIG. 1 to FIG. 3.
In a plan view of the light emitting element 1 in FIG. 1, two directions orthogonal to one another are designated as first direction X and second direction Y. The direction orthogonal to the first direction X and the second direction Y is designated as the third direction Z.

The light emitting element 1 includes a semiconductor structure 10, a light-transmissive conducting layer 43, an insulation film 20, and a first conducting layer 41.

### Semiconductor Structure

A semiconductor structure 10 is made of a nitride semiconductor. In the present specification, the term "nitride semiconductor" includes semiconductors having any compositions represented by the chemical formula InₓAl_{y}Ga_{1-x-y}N (0≤x≤1, 0≤y≤1, x+y≤1). Moreover, those further containing a group V element in addition to nitrogen (N), and those further containing various elements added for controlling various physical properties such as conductivity type are also included in the term "nitride semiconductor."

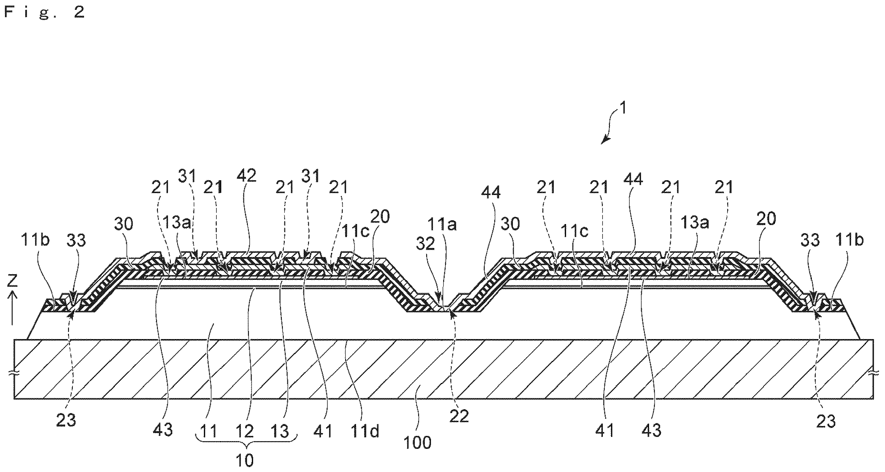

As shown in FIG. 2, the semiconductor structure 10 includes an n-side semiconductor layer 11, an active layer 12 positioned on the n-side semiconductor layer 11 in the third direction Z, and a p-side semiconductor layer 13 positioned on the active layer 12 in the third direction Z. The active layer 12 is located between the n-side semiconductor layer 11 and the p-side semiconductor layer 13 in the third direction Z. The active layer 12 is an emission layer configured to emit light and has a multiple quantum well (MQW) structure including multiple barrier layers and multiple well layers, for example. The n-side semiconductor layer 11 includes a semiconductor layer which includes an n-type impurity. The p-side semiconductor layer 13 includes a semiconductor layer which includes a p-type impurity.

The n-side semiconductor layer 11 has a first surface 11d, and a second surface 11c located opposite the first surface 11d in the third direction Z on which the active layer 12 and the p-side semiconductor layer 13 are disposed. The light emitted by the active layer 12 is extracted from the semiconductor structure 10 primarily through the first surface 11d. The n-side semiconductor layer 11 has multiple first exposed parts 11a positioned opposite the first surface 11d in the third direction Z and exposed from the p-side semiconductor layer 13 and the active layer 12. In a plan view, the maximum width of each of the first exposed parts 11a is 100 nm to 30 *µ*m, for example. The n-side semiconductor layer 11 further has multiple second exposed parts 11b positioned opposite the first surface 11d in the third direction Z and exposed from the p-side semiconductor layer 13 and the active layer 12.

As shown in FIG. 1, in the plan view, the n-side semiconductor layer 11 has two first outer edges 11A extending in the first direction X and two outer edges 11B extending in the second direction Y The second exposed parts 11b are located in the peripheral portion of the n-side semiconductor layer 11 adjacent to the first outer edges 11A and the second outer edges 11B in the plan view. The second exposed parts 11b are successive along the first outer edges 11A and the second outer edges 11B. The first exposed parts 11a are located inward of the peripheral portion of the n-side semiconductor layer 11 and enclosed by the p-side semiconductor layer 13 in the plan view. In the plan view, the length of a first outer edge 11A and a second outer edge 11B is, for example, in a range of 30 *µ*m to 2000 *µ*m.

As shown in FIG. 2, the light emitting element 1 can include a substrate 100 that supports the semiconductor structure 10. The semiconductor structure 10 is disposed on the substrate 100 such that the n-side semiconductor layer 11 is positioned on the substrate 100 side in the third direction Z. In FIG. 2, the substrate 100 is in contact with the first surface 11d. For the material of the substrate 100, for example, sapphire, spinel, GaN, SiC, ZnS, ZnO, GaAs, Si, or the like can be used. The light emitting element 1 does not necessarily include a substrate 100.

### Light-transmissive Conducting Layer

A light-transmissive conducting layer 43 is disposed on the upper surface 13a of the p-side semiconductor layer 13. The light-transmissive conducting layer 43 is configured to transmit the light emitted by the active layer 12. The transmittance of the light-transmissive conducting layer 43 with respect to the peak wavelength of the light from the active layer 12 is, for example, 60% or higher. This can reduce the absorption of light by the light-transmissive conducting layer 43.
The light-transmissive conducting layer 43 can diffuse the current supplied from the first conducting layer 41 in an in-plane direction of the p-side semiconductor layer 13. This can reduce the unevenness in the emission distribution. For the material of the light-transmissive conducting layer 43, for example, indium tin oxide (ITO), zinc oxide (ZnO), indium oxide (In₂O₃), or the like can be used.

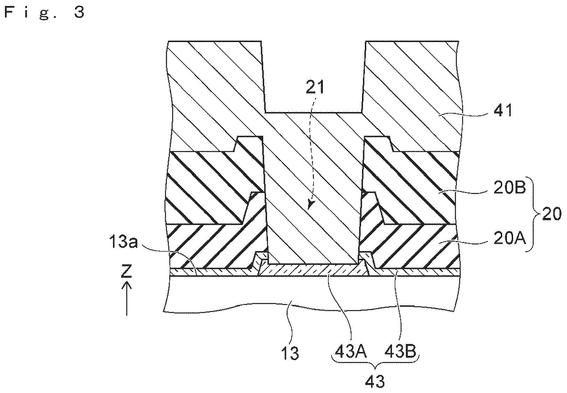

FIG. 3 is a schematic cross-sectional view of the region that includes a portion of the upper surface 13a of the p-side semiconductor layer 13. In the region shown in FIG. 3, the first conducting layer 41 described below is electrically connected to the light-transmissive conducting layer 43. As shown in FIG. 3, the light-transmissive conducting layer 43 includes a first layer 43A, which is disposed on a portion of the upper surface 13a of the p-side semiconductor layer 13 and in contact with the upper surface 13a, and a second layer 43B, which is in contact with the upper surface 13a of the p-side semiconductor layer 13 and covering the first layer 43A. The second layer 43B covers the upper surface 13a and a portion of the upper surface and the lateral surfaces of the first layer 43A. The contact area between the second layer 43B and the upper surface 13a of the p-side semiconductor layer 13 is greater than the contact area between the first layer 43A and the upper surface 13a of the p-side semiconductor layer 13. For example, the contact area between the first layer 43A and the upper surface 13a of the p-side semiconductor layer 13 is in a range of 0.1% to 5% of the contact area between the second layer 43B and the upper surface 13a of the p-side semiconductor layer 13.

A grain size of a portion of the second layer 43B located on the first layer 43A is greater than a grain size of the first layer 43A. Further, a grain size of a portion of the second layer 43B located on the first layer 43A is greater than a grain size of a portion of the second layer 43B located on the upper surface 13a of the p-side semiconductor layer 13 with no first layer 43A disposed therebetween.

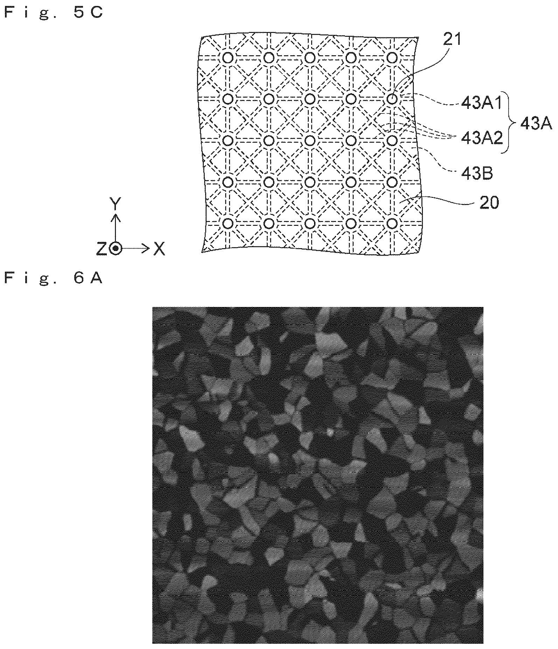

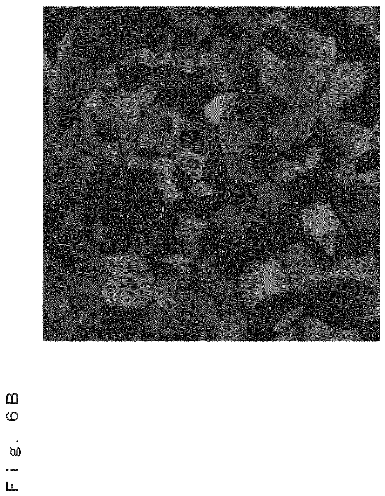

A grain size of the first layer 43A and a grain size of the second layer 43B can be measured from, for example, an image obtained by observation using an atomic force microscope (AFM). FIG. 6A shows an AFM image of the first layer 43A. FIG. 6B shows an AFM image of the second layer 43B on the first layer 43A. Both FIG. 6A and FIG. 6B show a region of 5 *µ*m ×5 *µ*m. A grain size of the first layer 43A is, for example, 0.35 nm or greater and 0.7 nm or less. A grain size of a portion of the second layer 43B located on the first layer 43A is, for example, 0.7 nm or greater and 1.0 nm or less.

A grain size of the first layer 43A and a grain size of the second layer 43B can also be measured from an image obtained by observation using a scanning electron microscope (SEM), transmission electron microscope (TEM), or kelvin force microscope (KFM).

With a grain size of a portion of the second layer 43B on the first layer 43A being greater than a grain size of the first layer 43A, a resistivity of the portion of the second layer 43B located on the first layer 43A can be lower than a resistivity of the first layer 43A.

### Insulation Film

An insulation film 20 is disposed on the p-side semiconductor layer 13 and covers the upper surface 13a of the p-side semiconductor layer 13 and the light-transmissive conducting layer 43.
The light radiated from the active layer 12 towards the p-side semiconductor layer 13 can be reflected by the insulation film 20 towards the first surface 11d which is a main light extraction surface. The insulation film 20 may be of a single layer structure, or a multilayer structure in which multiple insulation films are stacked as will be described later.

The insulation film 20 has a first opening 21 located above the light-transmissive conducting layer 43. As shown in FIG. 1, the insulation film 20 has a plurality of first openings 21. For example, the first openings 21 are arranged in rows and columns along the first direction X and the second direction Y in a plan view. The distance between adjacent first openings 21 can be set to be substantially the same. For example, in the plan view, the shortest distance from a first exposed part 11a to a first opening 21 positioned closest to the first exposed part 11a is in a range of 100 nm to 10 *µ*m. The number of first openings 21 can be, for example, 400 to 1500. The total area of the first openings 21 in a plan view is, for example, in a range of 0.2% to 5% of the area of the upper surface 13a of the p-side semiconductor layer 13. Setting the number and/or the total area of the first openings 21 as described above allows for securing the area for the electrical connection of the first conducting layer 41 and the p-side semiconductor layer 13 while maintaining the area of the insulation film 20 at which light is to be reflected. This can improve the emission efficiency of the light emitting element 1. For example, the maximum width of a first opening 21 in a plan view is, for example, in a range of 1 nm to 10 *µ*m.

In the example shown in FIG. 2, the insulation film 20 is continuously disposed on and covering the p-side semiconductor layer 13, the active layer 12, the first exposed parts 11a, and the second exposed parts 11b. The insulation film 20 also covers the lateral surface of the n-side semiconductor layer 11 that is continuous between the active layer 12 and the first exposed parts 11a and the lateral surface of the n-side semiconductor layer 11 that is continuous between the active layer 12 and the second exposed parts 11b. The insulation film 20 has third openings 22 positioned above the first exposed parts 11a and fourth openings 23 positioned above the second exposed parts 11b.

### First Conducting Layer

A first conducting layer 41 is disposed on the insulation film 20 and in the first openings 21. As shown in FIG. 3, the first conducting layer 41 is in contact with the light-transmissive conducting layer 43 at a location below the first openings 21 of the insulation film 20, and electrically connected to the light-transmissive conducting layer 43. The first conducting layer 41 is electrically connected to the p-side semiconductor layer 13 via the light-transmissive conducting layer 43. The first conducting layer 41 can also function as a layer at which light emitted from the active layer 12 toward the p-side semiconductor layer 13 is reflected toward the first surface 11d. The reflectance of the first conducting layer 41 with respect to the peak wavelength of the light from the active layer 12 is, for example, 60% or higher. For the material of the first conducting layer 41, for example, silver, aluminum, or the like can be used. The first conducting layer 41 may be of a single layer structure or multilayer structure in which multiple metal layers are stacked.

As shown in FIG. 3, at a location below the first opening 21, the first conducting layer 41 may penetrate the second layer 43B and may be in contact with the first layer 43A. In this case, a lateral surface of the first conducting layer 41 can be in contact with a portion of the second layer 43B on the first layer 43A. As described above, a resistivity of a portion of the second layer 43B on the first layer 43A is lower than a resistivity of the first layer 43A. With the lateral surface of the first conducting layer 41 being in contact with a portion of the second layer 43B on the first layer 43A, a contact resistance between the first conducting layer 41 and the light-transmissive conducting layer 43 can be reduced.

In another example, at a location below the first opening 21, the first conducting layer 41 does not penetrate the second layer 43B, and a lower surface of the first conducting layer 41 may be in contact with a portion of the second layer 43B on the first layer 43A. In this case, compared to a case in which the first conducting layer 41 penetrates the second layer 43B, a contact area between the first conducting layer 41 and a portion of the second layer 43B on the first layer 43A, which allows for reducing a contact resistance between the first conducting layer 41 and the light-transmissive conducting layer 43.

The light emitting element 1 according to the embodiment can further include an interlayer insulation film 30, a second conducting layer 44, and a third conducting layer 42.

### Interlayer Insulation Film

An interlayer insulation film 30 is disposed on the first conducting layer 41. The interlayer insulation film 30 has fifth openings 31 positioned above the first conducting layer 41. For the interlayer insulation film 30, for example, a silicon oxide film or a silicon nitride film can be used. The interlayer insulation film 30 may be of a single layer structure or multilayer structure in which multiple insulation films are stacked.

The interlayer insulation film 30 is continuously disposed on the first conducting layer 41 and the insulation film 20. The interlayer insulation film 30 has sixth openings 32 positioned above the first exposed parts 11a of the n-side semiconductor layer 11. In a plan view, the sixth openings 32 of the interlayer insulation film 30 overlap the third openings 22 of the insulation film 20 at least in part. The interlayer insulation film 30 has seventh openings 33 positioned above the second exposed parts 11b of the n-side semiconductor layer 11. In a plan view, the seventh openings 33 of the interlayer insulation film 30 at least partially overlap the fourth openings 23 of the insulation film 20.

### Second Conducting Layer

A second conducting layer 44 is disposed on the interlayer insulation film 30. The second conducting layer 44 is in contact with and electrically connected to the n-side semiconductor layer 11 at the third openings 22 of the insulation film 20 and the sixth openings 32 of the interlayer insulation film 30 disposed above the first exposed parts 11a. The second conducting layer 44 is also in contact with and electrically connected to the n-side semiconductor layer 11 at the fourth openings 23 of the insulation layer 20 and the seventh openings 33 of the interlayer insulation film 30 positioned above the second exposed parts 11b.

### Third Conducting Layer

As shown in FIG. 2, a third conducting layer 42 is disposed on the interlayer insulation film 30 located above the p-side semiconductor layer 13. The third conducting layer 42 is in contact with and electrically connected to the first conducting layer 41 at the fifth openings 31 of the interlayer insulation film 30. In the example shown in FIG. 1, the third conducting layer 42 has a rectangular shape, the longer side of which extends in the first direction X. The second conducting layer 44 encloses the third conducting layer 42 in the plan view. The area of the second conducting layer 44 is greater than the area of the third conducting layer 42 in the plan view.

For the material of the second conducting layer 44 and the third conducting layer 42, for example, silver (Ag), platinum (Pt), aluminum (Al), gold (Au), or the like can be used. Each of the second conducting layer 44 and the third conducting layer 42 may be of a single layer structure or multilayer structure in which multiple metal layers are stacked.

### Method of Manufacturing Light Emitting Element

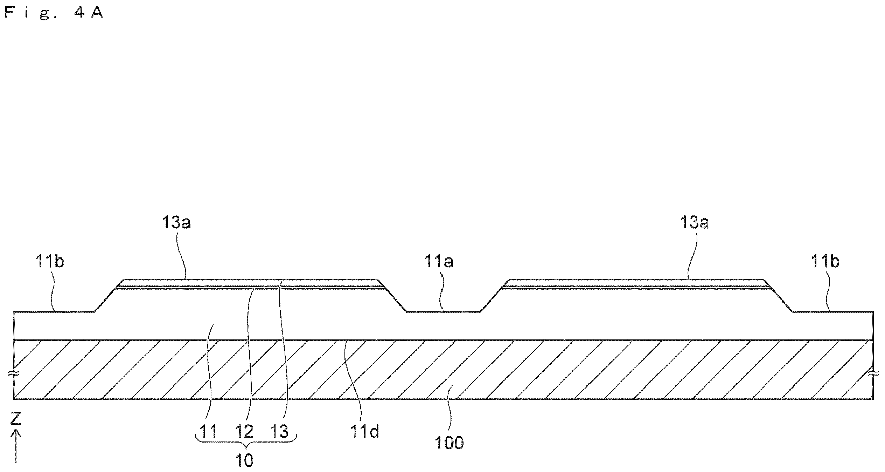

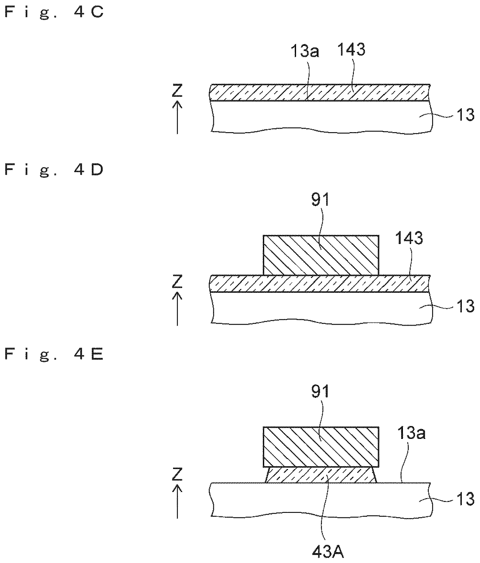

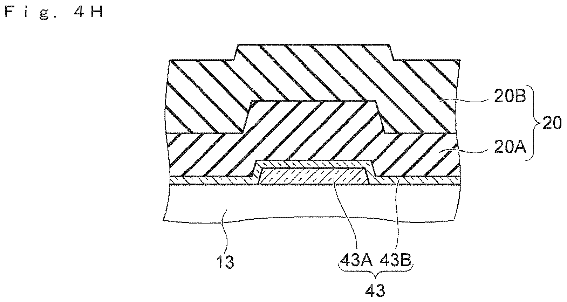

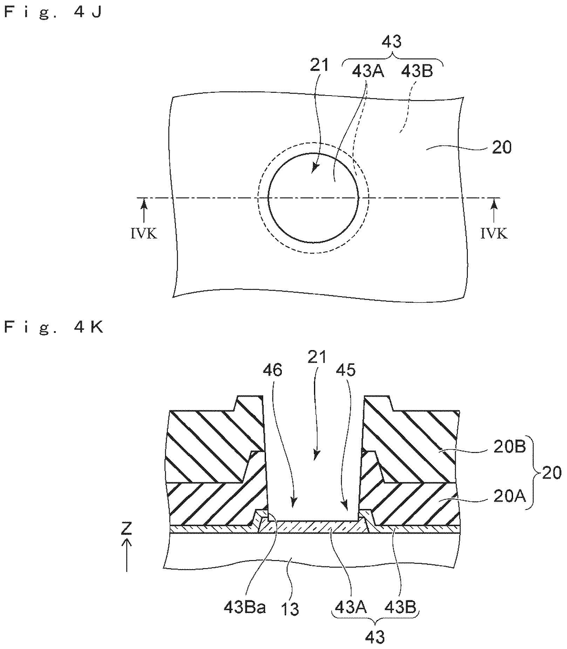

A method of manufacturing a light emitting element 1 according to the embodiment will be explained next with reference to FIG. 4A to FIG. 4O. FIG. 4C to FIG. 4F, FIG. 4H, and FIG. 4K are schematic cross-sectional views of the region that includes a portion of the upper surface 13a of the p-side semiconductor layer 13 shown in FIG. 3 described earlier. FIG. 4J is a schematic plan view of the region shown in FIG. 4K. FIG. 4J and FIG. 4K are schematic plan view and cross-sectional view illustrating the step of exposing the light-transmissive conducting layer 43 from the insulation film 20.

The method of manufacturing a light emitting element 1 includes providing a semiconductor structure 10, forming a light-transmissive conducting layer 43, forming an insulation film 20, exposing the light-transmissive conducting layer 43 from the insulation film 20, and forming a first conducting layer 41.

### Providing Semiconductor Structure

As shown in FIG. 4A, in the step of providing a semiconductor structure 10, a semiconductor structure 10 having an n-side semiconductor layer 11, an active layer 12 positioned on the n-side semiconductor layer 11, and a p-side semiconductor layer 13 positioned on the active layer 12 is provided.

The step of providing a semiconductor structure 10 includes successively forming on a substrate 100 an n-side semiconductor layer 11, an active layer 12, and a p-side semiconductor layer 13 by metal organic chemical vapor deposition (MOCVD), for example. The step of providing a semiconductor structure 10 further includes forming first exposed parts 11a and second exposed parts 11b in the n-side semiconductor layer 11. In one example, the first exposed parts 11a and the second exposed parts 11b can be formed by removing portions of the p-side semiconductor layer 13 and portions of the active layer 12 from the upper surface 13a side of the p-side semiconductor layer 13 by reactive ion etching (RIC) using a chlorine-based gas.

### Forming Light-transmissive Conducting Layer

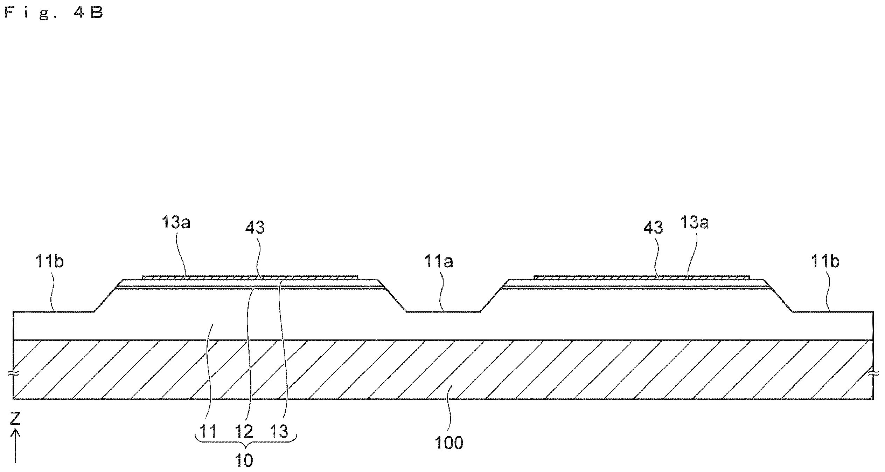

As shown in FIG. 4B, in the step of forming a light-transmissive conducting layer 43, a light-transmissive conducting layer 43 is formed on the upper surface 13a of the p-side semiconductor layer 13.

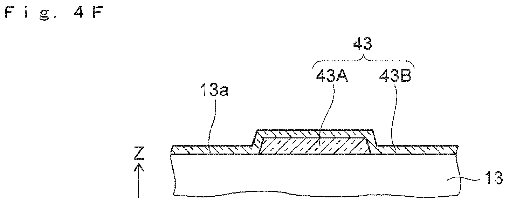

The step of forming a light-transmissive conducting layer 43, as shown in FIG. 4F, includes forming a first layer 43A on a portion of the upper surface 13a of the p-side semiconductor layer 13 and forming a second layer 43B that covers the upper surface 13a of the p-side semiconductor layer 13 and the first layer 43A. The first layer 43A is formed as a plurality of parts separated from each other at a plurality of locations on the upper surface 13a of the p-side semiconductor layer 13. In the forming of a second layer 43B, the second layer 43B covers the upper surface and the lateral surfaces of the first layer 43A. In the light-transmissive conducting layer 43, the maximum thickness of the portion in which the first layer 43A and the second layer 43B are stacked in the third direction Z is greater than the maximum thickness of the portion of the second layer 43B not covering the first layer 43A in the third direction Z.

### Forming Insulation Film

As shown in FIG. 4H, the insulation film 20 covers the second layer 43B of the light-transmissive conducting layer 43. The insulation film 20 can be formed by sputtering or chemical vapor deposition (CVD), for example.

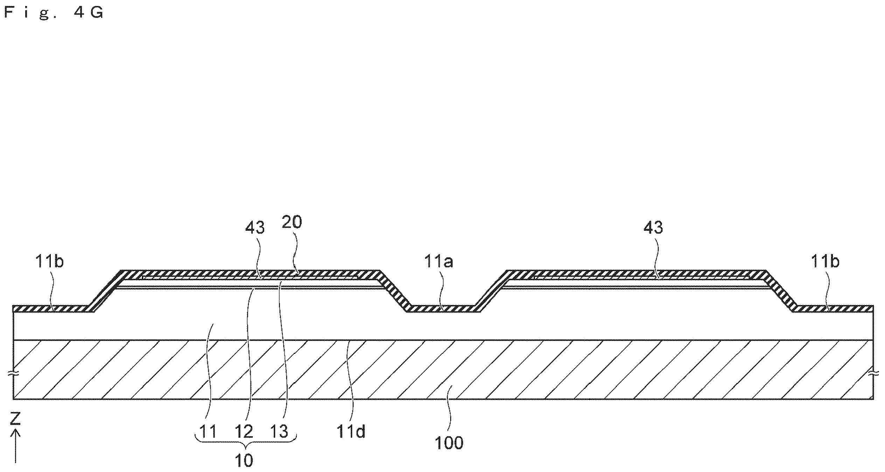

As shown in FIG. 4G, the insulation film 20 continuously covers the light-transmissive conducting layer 43 and surfaces of the semiconductor structure 10 located opposite the first surface 11d. The surfaces of the semiconductor structure 10 covered by the insulation film 20 include the upper surface 13a of the p-side semiconductor layer 13, the lateral surfaces of the p-side semiconductor layer 13, the lateral surfaces of the active layer 13, and the first exposed parts 11a and the second exposed parts 11b of the n-side semiconductor layer 11. The surfaces of the semiconductor structure 10 covered by the insulation film 20 further include the lateral surface of the n-side semiconductor layer 11 that is continuous with the first exposed parts 11a and the lateral surface of the n-side semiconductor layer 11 that is continuous with the second exposed parts 11b.

### Exposing Light-transmissive Conducting Layer from Insulation Film

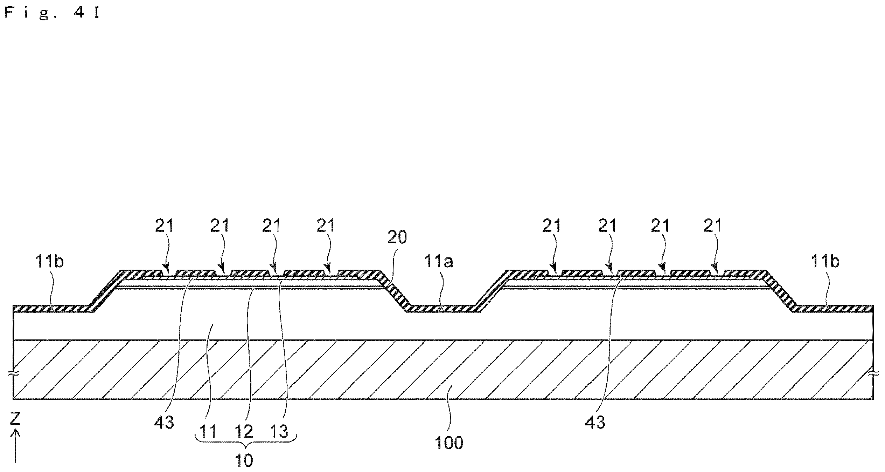

FIG. 4K is a schematic cross-sectional view taken along line IVK-IVK in FIG. 4J. As shown in FIG. 4J, a first opening 21 is formed in the insulation film 20 by removing the insulation film in a region of the light-transmissive conducting layer 43 that overlaps the first layer 43A in the plan view. In the plan view, the shapes of the first opening 21 and the first layer 43A can be circular. In the plan view, the outer periphery of the first opening 21 is positioned inward of the outer periphery of the first layer 43A. By creating a first opening 21, the light-transmissive conducting layer 43 is exposed from the insulation film 20 as shown in FIG. 4J and FIG. 4K. For example, as shown in FIG. 4I, a plurality of first openings 21 can be formed above the light-transmissive conducting layer 43. In the present embodiment, the number of first openings 21 is the same as the number of the locations at which the light-transmissive conducting layer 43 is formed.

The first openings 21 can be formed by removing portions of the insulation film 20 by RIE using a resist mask, for example. In the etching conditions for forming the first openings 21, the etch rate of the light-transmissive conducting layer 43 is lower than the etch rate of the insulation film 20.

### Forming First Conducting Layer

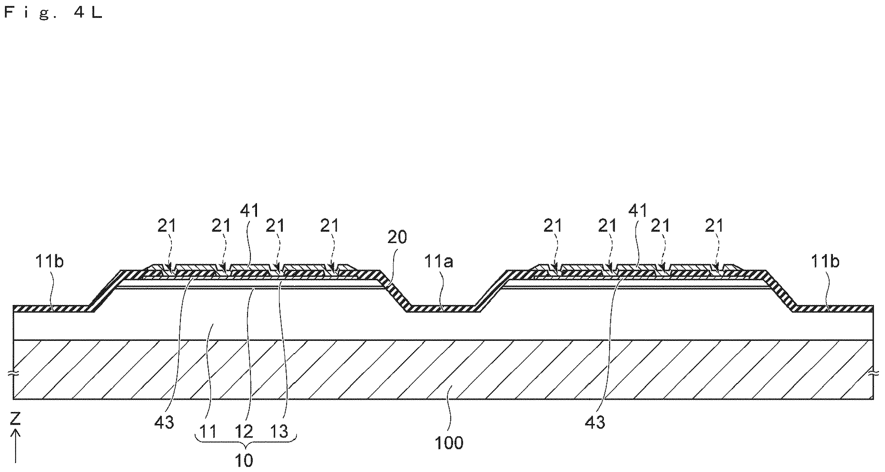

As shown in FIG. 4L and FIG. 3, a first conducting layer 41 is formed in the first openings 21. The first conducting layer 41 is electrically connected to the light-transmissive conducting layer 43 at a location below the first openings 21. The first conducting layer 41 is formed on the insulation film 20 located above the p-side semiconductor layer 13 and in the first openings 21. The first conducting layer 41 can be formed by, for example, sputtering.

According to this embodiment, in the step of exposing the light-transmissive conducting layer 43 from the insulation film 20, the first openings 21 are formed by removing portions of the insulation film 20 located above the portions of the light-transmissive conducting layer 43 where both the first layer 43A and the second layer 43B are located. The portions in each of which the first layer 43A and the second layer 43B are located are greater in thickness than the other portions of the light-transmissive conducting layer 43, and thus, when the first openings 21 are formed in the insulation film 20, the light-transmissive conducting layer 43 located below the first openings 21 is not easily eliminated. This can facilitate the light-transmissive conducting layer 43 to remain below the first openings 21, so that the first conducting layer 41 formed in the first openings 21 and the light-transmissive conducting layer 43 can be electrically connected together with higher reliability.

The portion of the light-transmissive conducting layer 43 in which only the second layer 43B is located is lesser in thickness than the portions of the light-transmissive conducting layer 43 in each of which both the first layer 43A and the second layer 43B are provided, so that the absorption of the light from the active layer 12 by the light-transmissive conducting layer 43 can be reduced. Thus, according to this embodiment, the light-transmissive conducting layer 43 and the first conducting layer 41 can be electrically connected more reliably, and the absorption of light by the light-transmissive conducting layer 43 can be reduced.

In the step of forming a light-transmissive conducting layer 43, a first layer 43A can be formed in portions of the upper surface 13a of the p-side semiconductor layer 13 by the method shown in FIG. 4C to FIG. 4E.

The forming of a first layer 43A, as shown in FIG. 4C, includes forming a first film 143 on the upper surface 13a of the p-side semiconductor layer 13. For example, the first film 143 can be formed on the upper surface 13a of the p-side semiconductor layer 13 by sputtering or vapor deposition. The first film 143 may be continuously formed on the upper surface 13a of the p-side semiconductor layer 13, the first exposed parts 11a, and the second exposed parts 11b. In this case, in the step of forming a first layer 43A as will be described below, the first film 143 formed on the first exposed parts 11a and the second exposed parts 1 1b will be removed.

The forming of a first layer 43A includes, subsequent to forming the first film 143, removing a portion of the first film 143 while another portion of the first film 143 remains as a first layer 43A on the upper surface 13a of the p-side semiconductor layer 13. For example, as shown in FIG. 4D, a resist mask 91 is placed on the portion of the first film 143 that is to remain. Then the portion of the first film 143 exposed from the resist mask 91 is etched off. This allows the portion of the first film 143 located under the resist mask 91 to remain as a first layer 43A on a portion of the upper surface 13a of the p-side semiconductor layer 13 as shown in FIG. 4E. A portion of the first film 143 is preferably removed by wet etching. Removing a portion of the first film 143 by wet etching allows for reducing the contact resistance between the upper surface 13a of the p-side semiconductor layer 13 and the second layer 43B described below as compared to the case of performing the removal by dry etching. This is thought to be because the etching damage to the upper face 13a of the p-side semiconductor layer 13 can be reduced as compared to the removal of a portion of the first film 143 by dry etching.

Then, as shown in FIG. 4F, a second layer 43B is formed to cover the upper surface 13a of the p-side semiconductor layer 13 and the first layer 43A. The second layer 43B can be formed by sputtering or vapor deposition. As shown in the cross-sectional view in FIG. 4B, a second layer 43B is formed at a position away from the first exposed parts 11a and the second exposed parts 11b. The location of the light-transmissive conducting layer 43 shown in FIG. 4B and the location where the second layer 43B is formed are the same. The second layer 43B is formed at a position away from the first exposed parts 11a and the second exposed parts 11b in a top view as well. After forming a film that will become the second layer 43B continuously on the upper surface 13a of the p-side semiconductor layer 13, the first exposed parts 11a, and the second exposed parts 11b, portions of the film located at the first exposed parts 11a and the second exposed parts 11b is removed. This allows the second layer 43B to remain in the locations away from the first exposed parts 11a and the second exposed parts 11b. Alternatively, the second layer 43B may be allowed to remain in the locations away from the first exposed parts 11a and the second exposed parts 11b by masking the first exposed parts 11a and the second exposed parts 11b, followed by forming a film which will become the second layer 43B over the mask on the upper surface 13a of the p-side semiconductor layer 13 and subsequently lifting off the mask.

As a first reference example of a method of forming a light-transmissive conducting layer that is partially thick, a method including a step of forming a first film on the upper surface 13a of the p-side semiconductor layer 13, and a step of covering a portion of the first film with a resist mask and thinning a portion of the first film exposed from the resist mask by partial removal using an etching technique can be considered. When using this method of the first reference example, however, thickness variation in the etched portion of the light-transmissive conducting layer is likely to occur.

As a second reference example of a method of forming a light-transmissive conducting layer that is partially thick, a method including a step of forming a first film on the upper surface 13a of the p-side semiconductor layer 13, a step of placing on the first film a resist mask having openings, a step of forming a second film on the resist mask and in the openings of the resist mask, and a step of removing the resist mask and the second film disposed on the resist mask by lift-off with the second film remaining on the first film at certain locations. When using this method of the second reference example, width variation is likely to occur in the openings of the resist mask in a plan view, which is likely to cause width variation in the thick portions of the light-transmissive conducting layer in the plan view.

The method described above shown in FIG. 4C to FIG. 4E does not include a step of thinning the first film by etching as in the first reference example, or a step of forming a second film in the openings of a resist mask as in the second reference example. Accordingly, both the thickness variation in the second layer 43B and the width variation in the first layer 43A in a plan view can be reduced.

In the exposing of the light-transmissive conducting layer 43 from the insulation film 20, as shown in FIG. 4K, a portion of the light-transmissive conducting layer 43 can be removed. The removal of a portion of the light-transmissive conducting layer 43 creates a recess 46 in the light-transmissive conducting layer 43 at the lower portion of a first opening 21. The recess 46 is continuous with the first opening 21. In the forming of a first conducting layer 41, the first conducting layer 41 is formed in the first opening 21 and the recess 46, and can be in contact with the light-transmissive conducting layer 43 at surfaces of the light-transmissive conducting layer 43 that define the lateral sides and the bottom of the recess 46 of the light-transmissive conducting layer 43. This allows for increasing the contact area between the first conducting layer 41 and the light-transmissive conducting layer 43 and thus reducing the forward voltage of the light emitting element as compared to the case in which the first conducting layer 41 is in contact only with the upper surface of the light-transmissive conducting layer 43.

In the case of removing a portion of the light-transmissive conducting layer 43 in the exposing of the light-transmissive conducting layer 43 from the insulation film 20, a portion of the second layer 43B in the region overlapping the first layer 43A in a plan view is removed to forming a second opening 45 in the second layer 43B, so that the first layer 43A can be exposed from the second layer 43B. The second opening 45 is continuous with the first opening 21 at the lower portion of the first opening 21. In the forming of a first conducting layer 41, a first conducting layer 41 to be electrically connected to the light-transmissive conducting layer 43 is formed in the first opening 21 and the second opening 45. The first conducting layer 41 can be in contact with the lateral surfaces 43Ba of the second layer 43B that define the lateral surfaces of the second opening 45. Forming a second opening 45 to expose the first layer 45A from the second layer 43B can increase the contact area between the first conducting layer 41 and the light-transmissive conducting layer 43 at the lateral surfaces 43Ba of the second layer 43B as compared to the case in which the first layer 43A is not exposed from the second layer 43B. This can further reduce the forward voltage of the light emitting element.

The thickness of the first layer 43A is preferably greater than the thickness of the second layer 43B. The thickness of the first layer 43A indicates the maximum thickness in the third direction Z. The thickness of the second layer 43B indicates the maximum thickness of the portion not covering the first layer 43A in the third direction Z. With the first layer 43A thicker than the second layer 43B the light-transmissive conducting layer 43 is less likely to be eliminated by the etching performed to remove the insulation film 20. Further, with the second layer 43B being thinner than the first layer 43A, the absorption of light by the light-transmissive conducting layer 43 can be reduced in the portion in which the first conducting layer 41 is not connected to the light-transmissive conducting layer 43. For example, the thickness of the first layer 43A can be set to 30 nm to 50 nm, and the thickness of the second layer 43B can be set in a range of 5 nm to 25 nm.

In the forming of the light-transmissive conducting layer 43, a contact area between the first layer 43A and the upper surface 13a of the p-side semiconductor layer 13 is less than a contact area between the second layer 43B and the upper surface 13a of the p-side semiconductor layer 13. This structure allows for reducing absorption of light by the first layer 43A. Accordingly, when a thickness of the first layer 43A is greater than a thickness of the second layer 43B, absorption of light by the first layer 43A can be reduced.

Performing heat treatment of the light-transmissive conducting layer 43 can reduce the contact resistance between the light-transmissive conducting layer 43 and the upper surface 13a of the p-side semiconductor layer 13. The heat treatment of the light-transmissive conducting layer 43 can be performed after forming a first layer 43A and again after forming a second layer 43B, or performed once following the formation of the first layer 43A and the second layer 43B.

In the case of making the thickness of the first layer 43A greater than that of the second layer 43B, the step of forming a light-transmissive conducting layer 43 can include performing a first heat treatment at a first temperature after forming a first layer 43A and before forming a second layer 43B, and performing a second heat treatment at a second temperature lower than the first temperature after forming a second layer 43B. The first temperature can be set, for example, to be higher than 350 °C and equal to or lower than 400 °C. The second temperature can be set, for example, to be in a range of 300 °C to 350 °C.

The first layer 43A is heated twice, i.e., in the first heat treatment and the second heat treatment, the contact resistance with the upper surface 13a of the p-side semiconductor layer 13 can be reduced as compared to the case in which the first layer is heated once in either the first heat treatment or the second heat treatment. This can reduce the resistance of the electrically connected portion between the first conducting layer 41 and the p-side semiconductor layer 13, which allows for reducing the forward voltage of the light emitting element. With the second layer 43B thinner than the first layer 43A, the contact resistance between the first layer 43A and the upper surface 13a of the p-side semiconductor layer 13 can be reduced by performing the second heat treatment alone which is conducted at a second temperature lower than the first heat treatment. Performing the first heat treatment and the second heat treatment at a second temperature lower than that in the first heat treatment can reduce the thermal damage to the semiconductor structure 10 as compared to the case in which heat treatment is conducted once after forming both the first layer 43A and the second layer 43B at a higher temperature than that in the first heat treatment.

By performing the first heat treatment after forming the first layer 43A, the first layer 43A, which is in an amorphous state before the first heat treatment, can be crystallized. Accordingly, etch controllability with respect to the first layer 43A in the step shown in FIG. 4E can be improved. In the step shown in FIG. 4F, the grain size of the first layer 43A is not inherited to the second layer 43B formed on the first layer 43A, and the grain size of the second layer 43B formed on the first layer 43A is greater than the grain size of the first layer 43A.

The step of forming an insulation film 20, as shown in FIG. 4H, can include forming a first insulation film 20A on the second layer 43B of the light-transmissive conducting layer 43 and forming a second insulation film 20B on the first insulation film 20A.

Forming a first insulation film 20A in contact with the light-transmissive conducting layer 43 allows light emitted from the active layer 12 to be totally reflected at the interface between the first insulation film 20A and the light-transmissive conducting layer 43, which allows the light to travel toward the first surface 11d of the semiconductor structure 10, which is the primary light extraction surface. For the first insulation film 20A, for example, a silicon oxide film or silicon nitride film can be used. The first insulation film 20A made of such a material can be etched by RIE using a fluorine-containing gas, for example, in the step of forming a first opening 21.

For the second insulation film 20B, for example, a distributed Bragg reflector (DBR) in which two types of films having different refractive indices are alternately stacked can be used. This allows the second insulation film 20B to reflect the light that transmitted through the first insulation film 20A toward the first surface 11d.

The second insulation film 20B includes, for example, alternately stacked SiO₂ films and Nb₂O₅ films. The number of pairs of SiO₂ film and Nb₂O₅ film in the second insulation film 20B can be set, for example, to be in range of 1 to 5. An Nb₂O₅ film tends to be less easily removed by wet etching. Accordingly, in the case in which the second insulation film 20B includes an Nb₂O₅ film, the second insulation film 20B is preferably etched by RIE in the step of forming a first opening 21. The second insulation film 20B that includes SiO₂ and Nb₂O₅ films can be etched by RIE using a fluorine-containing gas, for example. Accordingly, the first insulation film 20A and the second insulation film 20B made of the materials described above can be etched using the same gas (fluorine-containing gas). In the case of etching by RIE using a fluorine-containing gas, the etch rate of a light-transmissive conducting layer 43 made of ITO, ZnO, or In₂O₃, for example, is lower than the etch rate of the insulation film 20 made of the material described above. In the case of etching the insulation film 20 by RIE in the step of forming a first opening 21, the light-transmissive conducting layer 43 tends to be more easily etched than wet etching. According to this embodiment, a thickness of a portion of the light-transmissive conducting layer 43 located under the first openings 21 of the insulation film 20 is increased as described above, which allows the light-transmissive conducting layer 43 under the first openings 21 to be less easily eliminated even in the case of forming the first openings 21 by dry etching.

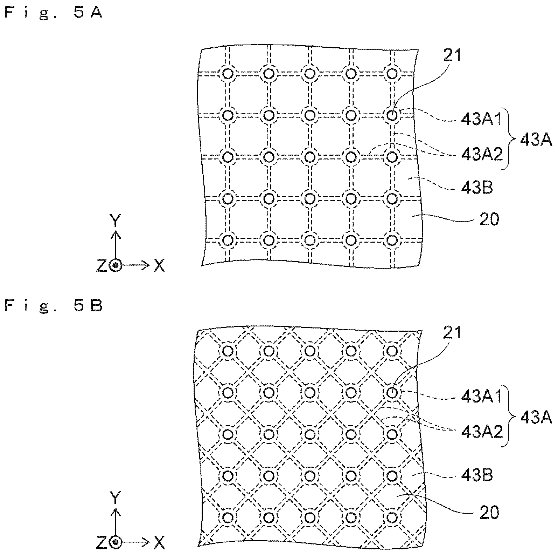

Each of FIG. 5A to FIG. 5C shows the state in which the first openings 21 are formed in the insulation film 20 on the light-transmissive conducting layer 43, and is an enlarged view of a portion of the light-transmissive conducting layer 43 and the insulation film 20 in a plan view. In the forming of a light-transmissive conducting layer 43, as shown in FIG. 5A to FIG. 5C, a first layer 43A having a plurality of first portions 43A1 and second portions 43A2 each connecting adjacent ones of the first portions 43A1 can be formed.

Each of the first portions 43A1 is positioned in the region overlapping a respective one of the plurality of first openings 21 in the plan view.

In the example shown in FIG. 5A, the second portions 43A2 extend in the first direction X and the second direction Y, and each of the second portions 43A2 connects adjacent ones of the first portions 43A1 in the plan view.
In the example shown in FIG. 5B, the second portions 43A2 extend in directions oblique to the first direction X and the second direction Y, and each of the second portions 43A2 connects adjacent ones of the first portions 43A1 in the plan view.
In the example shown in FIG. 5C, the second portions 43A2 extend in the first direction X, the second direction Y, and the directions oblique to both the first direction X and the second direction Y, and each of the second portions 43A2 connects adjacent ones of the first portions 43A1 in the plan view.

The second layer 43B of the light-transmissive conducting layer 43 covers a portion of the first portions 43A1 and the second portions 43A2. In a plan view, no first opening 21 is formed in the insulation film 20 in the areas overlapping the second portions 43A2. Accordingly, the portions of the light-transmissive conducting layer 43 where the second portions 43A2 are formed are not etched in the step of forming a first opening 21. The thickness of the portions of the light-transmissive conducting layer 43 in which the second portions 43A2 are formed is greater than the thickness of the light-transmissive conducting layer 43 in which only the second layer 43B is formed. With the thick portion, including the second portions 43A2, of the light-transmissive conducting layer 43 formed to connect adjacent ones of the first portions 43A1 connected to the first conducting layer 41, the diffusion of the current in an in-plane direction of the p-side semiconductor layer 13 can be facilitated as compared to the case in which the first layer 43A only includes the first portions 43A1, for example. This can reduce the unevenness in the current density distribution in an in-plane direction of the p-side semiconductor layer 13, and thus reducing the luminous intensity unevenness in the emission surface of the light emitting element.

As shown in FIG. 5A and FIG. 5C, in a plan view, a width of the second portion 43A2 extending in the first direction X is preferably less than a width of a first portion 43A1 in the second direction Y. As shown in FIG. 5A and FIG. 5C, in a plan view, a width of a second portion 43A2 extending in the second direction Y is preferably less than a width of the first portion 43A1 in the first direction X. Moreover, as shown in FIG. 5B and FIG. 5C, in a plan view, a width, in the direction orthogonal to the direction in which the second portion 43A2 extends, of a second portion 43A2 extending in a direction oblique to the first direction X and the second direction Y is preferably less than that of a first portion 43A1. With the widths of the first portions 43A1 and the second portions 43A2 satisfying these relationships in a plan view, the absorption of light by the second portions 43A2 can be reduced. In a plan view, the width in the second direction Y of a second portion 43A2 extending in the first direction X is, for example, in a range of 20% to 60% of the width in the second direction Y of a first portion 43A1. In a plan view, the width in the first direction X of a second portion 43A2 extending in the second direction Y is, for example, in a range of 20% to 60% of the width in the first direction X of a first portion 43A1. In a plan view, the width, in the direction orthogonal to the direction in which the second portion 43A2 extends, of a second portion 43A2 extending in a direction oblique to the first direction X and the second direction Y is, for example, in a range of 20% to 60% of the width of a first portion 43A1 in the direction oblique to the direction in which the second portion 43A2 extends. With the widths of the first portions 43A1 and the second portions 43A2 in a plan view within these ranges, the diffusion of current in an in-plane direction of the p-side semiconductor layer 13 can be facilitated.

The method of manufacturing a light emitting element 1 can further include, subsequent to the step of forming a first conducting layer 41, a step of forming an interlayer insulation film 30, a step of exposing the first conducting layer 41 from the interlayer insulation film 30, a step of exposing the first exposed parts 11a and the second exposed parts 11b from the interlayer insulation film 30 and the insulation film 20, a step of separating the semiconductor structure 10 into multiple elements 50, a step of forming a second conducting layer 44, and a step of forming a third conducting layer 42.

### Forming Interlayer Insulation Film

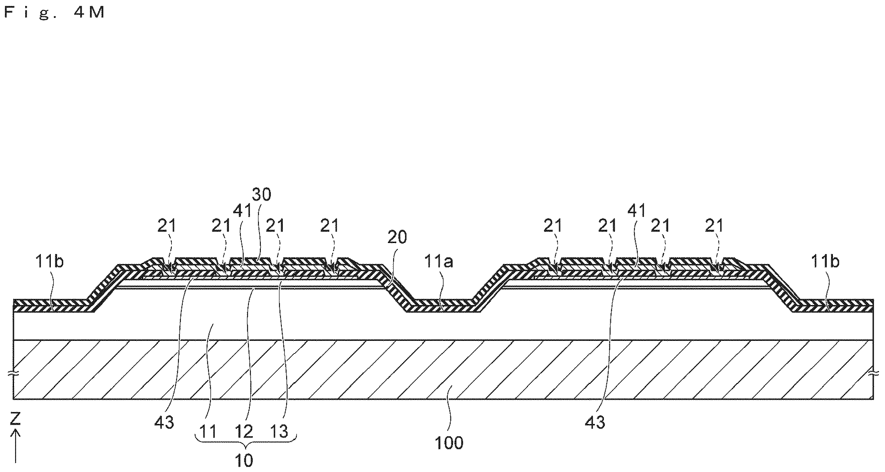

As shown in FIG. 4M, the interlayer insulation film 30 covers the first conducting layer 41 and the insulation film 20. The interlayer insulation film 30 can be formed by a method similar to that used in forming the insulation film 20.

### Exposing First Conducting Layer from Interlayer Insulation Film

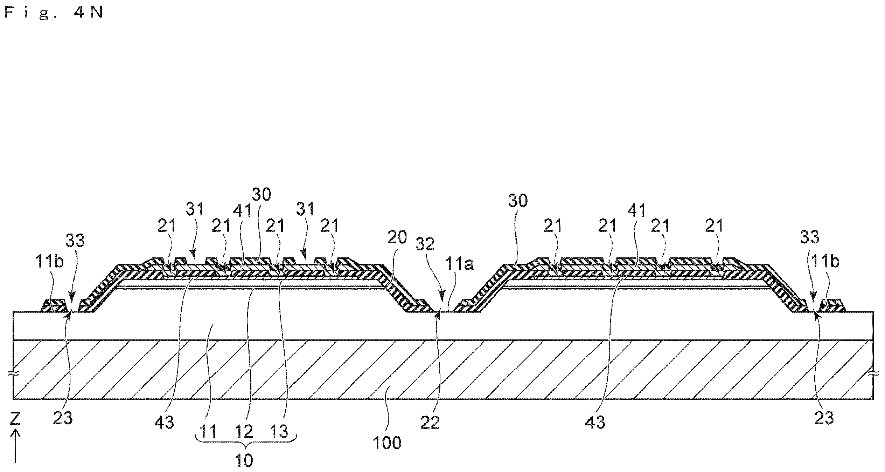

As shown in FIG. 4N, fifth openings 31 are created in the interlayer insulation film 30 on the first conducting layer 41. The first conducting layer 41 is exposed from the interlayer insulation film 30 at the fifth openings 31. For example, the fifth openings 31 can be formed in the interlayer insulation film 30 made of a silicon oxide film or silicon nitride film by RIE using a fluorine-containing gas.

### Exposing First Exposed Parts and Second Exposed Parts from Interlayer Insulation Film and Insulation Film

In the step of forming fifth openings 31, sixth openings 32 and seventh openings 33 can be formed in the interlayer insulation film 30, and third openings 22 and fourth openings 23 can be formed in the insulation film 20.

Each of the sixth openings 32 and a corresponding one of the third openings 22 are continuous with each other, and the first exposed parts 11a of the n-side semiconductor layer 11 are exposed from the interlayer insulation film 30 and the insulation film 20 at the sixth openings 32 and the third openings 22. Each of the seventh openings 33 and a corresponding one of the fourth openings 23 are continuous with each other, and the second exposed parts 1 1b of the n-side semiconductor layer 11 are exposed from the interlayer insulation film 30 and the insulation film 20 at the seventh openings 33 and the fourth openings 23.

### Separating Semiconductor Structure into Multiple Elements

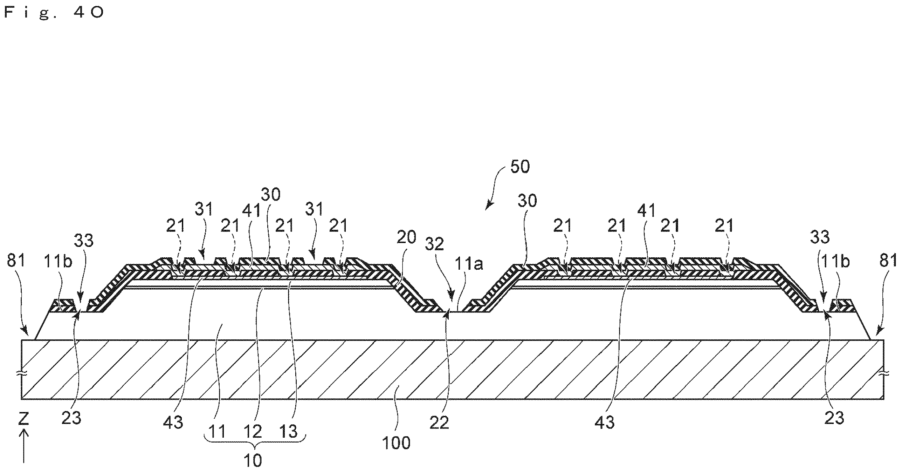

As shown in FIG. 4O, grooves 81 reaching the substrate 100 are created in the semiconductor structure 10 to separate the semiconductor structure 10 into multiple elements 50 on the substrate 100. For example, the grooves 81 can be formed by removing portions of the semiconductor structure 10 by RIE using a chlorine-containing gas.

### Forming Second Conducting Layer and Forming Third Conducting Layer

After separating the semiconductor structure 10 into multiple elements 50, a third conducting layer 42 is formed on the interlayer insulation film 30 and in the fifth openings 31 above the p-side semiconductor layer 13 as shown in FIG. 2. The third conducting layer 42 can be formed by a method similar to that used in forming the first conducting layer 41, for example. The third conducting layer 42 is in contact with the first conducting layer 41 at the fifth openings 31 and is electrically connected to the first conducting layer 41.

In the step of forming a third conducting layer 42, a second conducting layer 44 can also be formed on the interlayer insulation film 30 at the same time. For example, after continuously forming a conducting layer which will become a third conducting layer 42 and a second conducting layer 44 on the interlayer insulation film 30, a portion of the conducting layer is removed by RIE to separate the conducting layer into the third conducting layer 42 and the second conducting layer 44. Alternatively, after forming the conducting layer on the interlayer insulation film 30 with a resist disposed on the interlayer insulation film 30 between the region for forming a third conducting layer 42 and the region for forming a second conducting layer 44, the resist is removed, resulting in obtaining the third conducting layer 42 and the second conducting layer 44.

The second conducting layer 44 is formed in the sixth openings 32 and the third openings 22 and is in contact with the first exposed parts 11a of the n-side semiconductor layer 11. Furthermore, the second conducting layer 44 is formed in the seventh openings 33 and the fourth openings 23 and is in contact with the second exposed parts 1 1b of the n-side semiconductor layer 11. The second conducting layer 44 is electrically connected to the n-side semiconductor layer 11 at the first exposed parts 11a and the second exposed parts 11b.

Certain embodiments of the present invention can include the method of manufacturing a light emitting element and the light emitting element that are to be described below.

### Aspect 1

A method of manufacturing a light emitting element, the method including: providing a semiconductor structure including: an n-side semiconductor layer, an active layer positioned on the n-side semiconductor layer, and a p-side semiconductor layer positioned on the active layer; forming a light-transmissive conducting layer including: a first layer positioned on a portion of the upper surface of the p-side semiconductor layer, and a second layer covering the upper surface of the p-side semiconductor layer and the first layer; forming an insulation film covering the second layer; removing a portion of the insulation film in a region that overlaps the first layer in a plan view to form a first opening in the insulation film and to thereby expose the light-transmissive conducting layer from the insulation film; and forming a first conducting layer in the first opening such that the first conductive layer is electrically connected to the light-transmissive conducting layer.

### Aspect 2

The method of manufacturing a light emitting element according to Aspect 1 wherein: the step of forming the light-transmissive conducting layer includes forming the first layer and forming the second layer; and the step of forming the first layer includes: forming a first film on the upper surface of the p-side semiconductor layer, and removing a first portion of the first film such that a second portion of the first film remains as the first layer on the portion of the upper surface of the p-side semiconductor layer.

### Aspect 3

The method of manufacturing a light emitting element according to Aspect 1 or 2 wherein: in the step of exposing the light-transmissive conducting layer from the insulation film, a portion of the light-transmissive conducting layer is removed.

### Aspect 4

The method of manufacturing a light emitting element according to Aspect 3 wherein: in the step of exposing the light-transmissive conducting layer from the insulation film, a portion of the second layer in a region that overlaps the first layer in a plan view is removed to form a second opening in the second layer and to thereby expose the first layer from the second layer, and in the step of forming the first conducting layer, the first conducting layer electrically connected to the light-transmissive conducting layer is formed in the first opening and the second opening.

### Aspect 5

The method of manufacturing a light emitting element according to any one of Aspects 1 to 4 wherein: a thickness of the first layer is greater than a thickness of the second layer.

### Aspect 6

The method of manufacturing a light emitting element according to Aspect 5 wherein: a thickness of the first layer is in a range of 30 nm to 50 nm, and a thickness of the second layer is in a range of 5 nm to 25 nm.

### Aspect 7

The method of manufacturing a light emitting element according to Aspect 5 or 6 wherein: the step of forming the light-transmissive conducting layer includes: performing a first heat treatment at a first temperature higher than 350 °C and 400 °C or lower after forming the first layer and before forming the second layer, and performing a second heat treatment at a second temperature in a range of 300 °C to 350 °C after forming the second layer.

### Aspect 8

The method of manufacturing a light emitting element according to any one of Aspects 1 to 7 wherein: in the step of exposing the light-transmissive conducting layer from the insulation film, a plurality of first openings are formed; and the first layer has first portions located in the regions that overlap the first openings and second portions connecting the first portions in a plan view.

### Aspect 9

The method of manufacturing a light emitting element according to any one of Aspects 1 to 8, wherein: in the step of forming the light-transmissive conducting layer, a contact area between the first layer and the upper surface of the p-side semiconductor layer is less than a contact area between the second layer and the upper surface of the p-side semiconductor layer.

### Aspect 10

A light emitting element including: a semiconductor structure including: an n-side semiconductor layer, an active layer positioned on the n-side semiconductor layer, and a p-side semiconductor layer positioned on the active layer; a light-transmissive conducting layer including: a first layer positioned on a portion of the upper surface of the p-side semiconductor layer, and a second layer covering the upper surface of the p-side semiconductor layer and the first layer; an insulation film covering the second layer and having a first opening located in a region overlapping the first layer in a plan view; and a first conducting layer disposed in the first opening and in contact with the light-transmissive conducting layer at a location below the first opening; wherein: a grain size of a portion of the second layer located on the first layer is greater than a grain size of the first layer.

### Aspect 11

The light emitting element according to Aspect 10, wherein: a thickness of the first layer is greater than a thickness of the second layer.

### Aspect 12

The light emitting element according to Aspect 11, wherein: a thickness of the first layer is 30 nm or greater and 50 nm or less, and a thickness of the second layer is 5 nm or greater and 25 nm or less.

### Aspect 13

The light emitting element according to any one of Aspects 10 to 12, wherein: a grain size of the first layer is 0.35 nm or greater and 0.7 nm or less; and a grain size of a portion of the second layer located on the first layer is 0.7 nm or greater and 1.0 nm or less.

In the foregoing, certain embodiments of the present invention have been explained with reference to specific examples. The present invention, however, is not limited to these specific examples. All forms implementable by a person skilled in the art by suitably making design changes based on any of the embodiments of the present invention described above also fall within the scope of the present invention so long as they encompass the subject matter of the present invention. Furthermore, various modifications and alterations within the spirit of the present invention that could have been made by a person skilled in the art also fall within the scope of the present invention.

## Claims

1. A method of manufacturing a light emitting element, the method comprising:
providing a semiconductor structure comprising:
an n-side semiconductor layer,
an active layer positioned on the n-side semiconductor layer, and
a p-side semiconductor layer positioned on the active layer;
forming a light-transmissive conducting layer comprising:
a first layer positioned on a portion of the upper surface of the p-side semiconductor layer, and
a second layer covering the upper surface of the p-side semiconductor layer and the first layer;
forming an insulation film covering the second layer;
removing a portion of the insulation film in a region that overlaps the first layer in a plan view to form a first opening in the insulation film and to thereby expose the light-transmissive conducting layer from the insulation film; and
forming a first conducting layer in the first opening such that the first conductive layer is electrically connected to the light-transmissive conducting layer.

2. The method of manufacturing a light emitting element according to claim 1 wherein:
the step of forming the light-transmissive conducting layer comprises forming the first layer and forming the second layer; and
the step of forming the first layer comprises:
forming a first film on the upper surface of the p-side semiconductor layer, and
removing a first portion of the first film such that a second portion of the first film remains as the first layer on the portion of the upper surface of the p-side semiconductor layer.

3. The method of manufacturing a light emitting element according to claim 1 or 2 wherein:
in the step of exposing the light-transmissive conducting layer from the insulation film, a portion of the light-transmissive conducting layer is removed.

4. The method of manufacturing a light emitting element according to claim 3 wherein:
in the step of exposing the light-transmissive conducting layer from the insulation film, a portion of the second layer in a region that overlaps the first layer in a plan view is removed to form a second opening in the second layer and to thereby expose the first layer from the second layer, and
in the step of forming the first conducting layer, the first conducting layer electrically connected to the light-transmissive conducting layer is formed in the first opening and the second opening.

5. The method of manufacturing a light emitting element according to any one of claims 1 to 4 wherein:
a thickness of the first layer is greater than a thickness of the second layer.

6. The method of manufacturing a light emitting element according to claim 5 wherein:
a thickness of the first layer is in a range of 30 nm to 50 nm, and a thickness of the second layer is in a range of 5 nm to 25 nm.

7. The method of manufacturing a light emitting element according to claim 5 or 6 wherein:
the step of forming the light-transmissive conducting layer comprises:
performing a first heat treatment at a first temperature higher than 350 °C and 400 °C or lower after forming the first layer and before forming the second layer, and
performing a second heat treatment at a second temperature in a range of 300 °C to 350 °C after forming the second layer.

8. The method of manufacturing a light emitting element according to any one of claims 1 to 7 wherein:
in the step of exposing the light-transmissive conducting layer from the insulation film, a plurality of first openings are formed; and
the first layer has first portions located in the regions that overlap the first openings and second portions connecting the first portions in a plan view.

9. The method of manufacturing a light emitting element according to any one of claims 1 to 8, wherein:
in the step of forming the light-transmissive conducting layer, a contact area between the first layer and the upper surface of the p-side semiconductor layer is less than a contact area between the second layer and the upper surface of the p-side semiconductor layer.

10. A light emitting element comprising:
a semiconductor structure comprising:
an n-side semiconductor layer,
an active layer positioned on the n-side semiconductor layer, and
a p-side semiconductor layer positioned on the active layer;
a light-transmissive conducting layer comprising:
a first layer positioned on a portion of the upper surface of the p-side semiconductor layer, and
a second layer covering the upper surface of the p-side semiconductor layer and the first layer;
an insulation film covering the second layer and having a first opening located in a region overlapping the first layer in a plan view; and
a first conducting layer disposed in the first opening and in contact with the light-transmissive conducting layer at a location below the first opening; wherein:
a grain size of a portion of the second layer located on the first layer is greater than a grain size of the first layer.

11. The light emitting element according to claim 10, wherein:
a thickness of the first layer is greater than a thickness of the second layer.

12. The light emitting element according to claim 11, wherein:
a thickness of the first layer is 30 nm or greater and 50 nm or less, and a thickness of the second layer is 5 nm or greater and 25 nm or less.

13. The light emitting element according to any one of claims 10 to 12, wherein:
a grain size of the first layer is 0.35 nm or greater and 0.7 nm or less; and
a grain size of a portion of the second layer located on the first layer is 0.7 nm or greater and 1.0 nm or less.
